# EUROPEAN PATENT APPLICATION

(11) **EP 4 726 502 A1**
(43) Date of publication of application: **15.04.2026**
(21) Application number: 25206196.5
(22) Date of filing: 01.10.2025
(51) Int. Cl.: G06F 1/187, G06F 1/188, H05K 7/14, F16J 15/00

(54) **SCRATCH PROTECTION GUARD**

(30) Priority: 10.10.2024 IN 202421077034
(71) Applicant: Vertiv Corporation, Westerville, OH 43082 (US)
(72) Inventor: JETHVA, KISHAN JAYSUKH-BHAI, Westerville, 43082 (US); JAGTAP, SANKET RAJENDRA, Westerville, 43082 (US); CHOBHE, SHRIKANT VIVEK, Westerville, 43082 (US)
(74) Representative: Cousens, Nico

(57) **Abstract**

The present invention provides a scratch protection guard **100,** comprises a top section **101** having a pre-formed portion **101a** configured to remain visible on a top surface of a shelf **200** after installation, wherein the pre-formed portion **101a** is shaped as a frustum to provide a sliding surface to a sliding component **300.** Further, a middle section **102** is provided which includes a cylindrical portion **102a** configured to pass through a slot **204** of the shelf **200,** wherein the cylindrical portion **102a** has a height substantially equal to a thickness of the shelf **200.** Further, a bottom section **103** is provided with a deformable portion **103a** shaped as an inverted frustum, wherein the deformable portion **103a** is configured to deform during insertion into the slot **204** of the shelf **200** and return to its original shape after insertion to secure the scratch protection guard on the shelf **200.**

## Description

### FIELD OF DISCLOSURE

The present disclosure relates to the field of protective devices. In particular, the present disclosure provides a scratch protection guard that protects the surface of a shelf from scratches.

### BACKGROUND OF THE DISCLOSURE

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches, which in and of themselves may also correspond to implementations of the present technology.

In various industrial settings, such as data centers, telecommunications equipment installations, and power distribution units, sliding mechanisms are commonly used to mount components like expansion boxes onto shelves. During the sliding process, direct surface-to-surface contact can occur between the shelf and the mounted components, leading to scratches on the shelf surface. Such scratches not only diminish the aesthetic appearance of the shelf but can also result in functional impairments, particularly when the metal surface is damaged.

Existing methods to prevent such damage typically involve applying protective coatings or additional layers to the shelf surface. However, these solutions are often temporary, may introduce unnecessary complexity to the assembly process, and may not adequately address a critical concern, i.e., heat dissipation. In environments where electronic components generate significant heat, effective heat dissipation is essential to maintaining operational performance and preventing overheating.

Therefore, there exists a need for a scratch protection guard that offers a durable, efficient, and simplified solution to prevent surface damage while also facilitating heat dissipation during assembly operations.

### OBJECTIVE OF THE DISCLOSURE

An objective of the present disclosure is to provide a scratch protection guard that prevents surface damage to shelves during the sliding and assembly of sliding components.

Yet another objective of the present disclosure is to create a simplified, durable solution that integrates a snap-fit scratch protection guard for easy installation and replacement on the shelf surface without the need for complex tools.

Yet another objective of the present disclosure is to provide a scratch protection guard to enhance heat dissipation by maintaining an air gap between the shelf and the sliding component, thereby improving thermal regulation and preventing overheating of electronic equipment.

Yet another objective of the present disclosure is to provide an universally adaptable scratch protection guard that can be used across various shelf designs and industrial applications, such as data centers, telecom equipment, and power distribution units.

Yet another objective of the present disclosure is to offer a cost-effective solution for protecting surfaces from scratches, abrasions, and wear in various industrial applications.

These and other objects of the present disclosure will become more readily apparent from the following detailed description, which should be understood to illustrate, but not limit, the scope of the disclosure.

### SUMMARY OF THE DISCLOSURE

This summary is provided to introduce aspects related to a scratch protection guard that prevents surface damage to shelves during the sliding and assembly of sliding components, and the aspects are further described below in the detailed description. This summary is not intended to identify essential features of the present subject matter, nor is it intended for use in determining or limiting the scope of the present subject matter.

According to an embodiment of the present disclosure, a scratch protection guard is provided. The scratch protection guard comprises a top section having a pre-formed portion configured to remain visible on a top surface of a shelf after installation, wherein the pre-formed portion is shaped as a frustum to provide a sliding surface to a sliding component. Further, a middle section is provided which includes a cylindrical portion configured to pass through a slot of the shelf, wherein the cylindrical portion has a height substantially equal to a thickness of the shelf. Further, a bottom section is provided with a deformable portion shaped as an inverted frustum, wherein the deformable portion is configured to deform during insertion into the slot of the shelf and return to its original shape after insertion to secure the scratch protection guard on the shelf.

In an embodiment, the cylindrical portion has a cross-sectional shape selected from the group consisting of circular, rectangular, square, or any other regular shape.

In an embodiment, the scratch protection guard is made of Polyether ether ketone (PEEK) plastic, enabling durability and heat resistance suitable for use in environments where temperature regulation is critical.

In an embodiment, the pre-formed portion of the top section is configured to provide a physical barrier between the sliding component and the shelf, thereby preventing mechanical damage during relative motion.

In an embodiment, the frustum shape of the pre-formed portion is designed to enhance structural strength of the guard, providing resistance against impact forces from the sliding component.

In an embodiment, the top section comprises a textured surface to increase friction and prevent unwanted movement of the sliding component when it is in contact with the guard.

In a further embodiment, the cylindrical portion of the middle section includes a taper or threading to facilitate a secure fit within the slot of the shelf.

In an embodiment, the deformable portion of the bottom section is configured with radial slots or grooves to enhance its flexibility during insertion into the slot of the shelf.

In an embodiment, the deformable portion's inverted frustum shape is designed to act as a locking mechanism that automatically engages upon full insertion through the slot of the shelf.

In an embodiment, the top section is coated with a thermally conductive material to improve heat dissipation from electronic components mounted on the shelf.

In an additional embodiment, the scratch protection guard further comprises integrated cooling fins on the top section to increase surface area for heat dissipation.

In an embodiment, the bottom section includes a retention flange that prevents over-insertion through the slot of the shelf, ensuring precise alignment.

In an embodiment, the pre-formed portion is embossed with identification markings for quick visual inspection and inventory management.

In an embodiment, the pre-formed portion has a modular design that allows for customization based on specific requirements of different shelving systems.

In an embodiment, material of the top section includes anti-static properties to prevent electrostatic discharge in sensitive electronic environments.

In an embodiment, the deformable portion of the bottom section is configured to automatically return to its original shape after deformation due to its memory-like material properties.

In an embodiment, the deformable portion of the bottom section is made from a thermoplastic elastomer material to provide enhanced flexibility and wear resistance.

In yet another embodiment, the top section is designed with a low-profile configuration to minimize obstruction while providing adequate protection and thermal dissipation.

In another embodiment, the deformable portion includes a reinforcing rib structure to improve its strength and durability under repeated loading cycles.

In additional embodiment, the top section includes a detachable cover that provides additional protection to the pre-formed portion and can be replaced independently if worn out.

According to yet another embodiment, a shelf assembly is provided which comprises a shelf having a plurality of slots strategically positioned to receive scratch protection guards. Further, a plurality of scratch protection guards mounted in the slots of the shelf, each scratch protection guard comprising a top section with a pre-formed frustum-shaped portion visible on a surface of the shelf, wherein the pre-formed portion is shaped as a frustum to provide a sliding surface to a sliding component. Further, the scratch protection guard includes a middle section with a cylindrical portion that fits through the slot of the shelf and a bottom section with a deformable inverted frustum-shaped portion that deforms during insertion and regains its original shape to secure the scratch protection guard within the slot.

In an embodiment, the scratch protection guard is positioned at contact points where the sliding component is most likely to come into contact with the shelf to prevent scratching and facilitate thermal dissipation.

In an embodiment, the deformable portion of each scratch protection guard ensures snap-fit installation into the slots of the shelf, allowing for easy installation and removal without the need for additional hardware or tools.

In an additional embodiment, the shelf assembly further comprises an adhesive layer or bonding agent between the scratch protection guard and the shelf to enhance stability and prevent accidental dislodgment.

In an embodiment, the scratch protection guards are distributed in a predefined pattern that corresponds to expected motion path of the sliding component to maximize protection coverage.

In a further embodiment, the scratch protection guards are spaced apart at a distance calculated to distribute load evenly when the sliding component is in motion.

According to yet another embodiment, a system for protecting and enhancing the longevity of a shelf during the operation of a sliding component is provided. The system comprises a shelf having a surface with a plurality of slots and a sliding component mounted on the shelf. A plurality of scratch protection guards installed in the slots of the shelf, each scratch protection guard comprising: a top section with a pre-formed frustum-shaped portion that maintains an air gap between the shelf and the sliding component to facilitate thermal dissipation, a middle section with a cylindrical portion passing through the slots in the shelf and a bottom section with a deformable portion configured to secure the scratch protection guard within the slot upon insertion.

In an embodiment, the scratch protection guards are evenly distributed along the shelf in areas beneath the sliding component to protect the shelf surface from scratches caused by the movement of the sliding component.

In an embodiment, the scratch protection guard's pre-formed portion in the top section prevents direct contact between the shelf and the sliding component, thereby providing a protective barrier against wear and tear. Further, the scratch protection guard material is capable of withstanding operating temperatures up to 260°C and has a melting point of approximately 343°C, providing long-term resistance to thermal stress in environments like data centers and telecom equipment assemblies.

In a further embodiment, the air gap created by the pre-formed portion of the scratch protection guard reduces heat transfer between the shelf and the sliding component, thereby enhancing cooling efficiency.

In a further embodiment, the scratch protection guard is designed to withstand mechanical vibrations and shocks, maintaining its position and effectiveness even under dynamic loading conditions.

In a further embodiment, one or more mechanisms may be provided for easy replacement of the scratch protection guard without the need to disassemble the entire shelf or sliding component assembly.

In a further embodiment, the sliding component may be equipped with complementary alignment features that interface with the pre-formed portion of the scratch protection guard to ensure a smooth and guided sliding motion.

Other aspects and advantages of the disclosure will become apparent from the following description, taken in conjunction with the accompanying drawings, illustrating by way of example the principles of the disclosure.

### BRIEF DESCRIPTION OF THE DRAWINGS

The accompanying drawings constitute a part of the description and are used to provide a further understanding of the present disclosure;
**Figure 1A** illustrates a top-perspective view of a scratch protection guard, according to an embodiment of the present disclosure;
**Figure 1B** illustrates a bottom-perspective view of the scratch protection guard;
**Figure 2A** illustrates a perspective view of an exemplary configurations and placements of multiple scratch protection guards on a shelf, according to an embodiment of the present disclosure;
**Figure 2B** illustrates a perspective view of a sliding component mounted on the shelf, according to an embodiment of the present disclosure; and
**Figure 2C** illustrates a cross-sectional view of the sliding component mounted on the shelf.

A more complete understanding of the present disclosure and its embodiments thereof may be acquired by referring to the following description and the accompanying drawings.

### LIST OF REFERENCE NUMERALS

**100**- scratch protection guard
**200**- shelf
**300**- sliding component
**101**- top section
**101a**- pre-formed portion
**102**- middle section
**102A**- cylindrical portion
**103**- bottom section
**103a**- deformable portion
**204**- slots

### DETAILED DESCRIPTION OF THE DISCLOSURE

Exemplary embodiments now will be described with reference to the accompanying drawings. The disclosure may, however, be embodied in many different forms and should not be construed as limited to the embodiments set forth herein; rather, these embodiments are provided so that this disclosure will be thorough and complete, and will fully convey its scope to those skilled in the art. The terminology used in the detailed description of the particular exemplary embodiments illustrated in the accompanying drawings is not intended to be limiting. In the drawings, like numbers refer to like elements.

It is to be noted, however, that the reference numerals used herein illustrate only typical embodiments of the present subject matter, and are therefore, not to be considered for limiting its scope, for the subject matter may admit to other equally effective embodiments.

The detailed description includes specific details for the purpose of providing a thorough understanding of the present disclosure. However, it will be apparent to those skilled in the art that the present disclosure may be practiced without these specific details.

In industrial settings such as data centers, telecommunications installations, and power distribution units, sliding mechanisms are commonly used to mount components, like expansion boxes, onto shelves. However, this sliding process often leads to direct surface-to-surface contact, causing scratches on the shelf. These scratches not only affect the shelf's appearance but can also result in functional impairments, especially if metal surfaces are damaged. Therefore, there is a need for a durable and efficient scratch protection guard that prevents surface damage while ensuring proper heat dissipation during assembly operations.

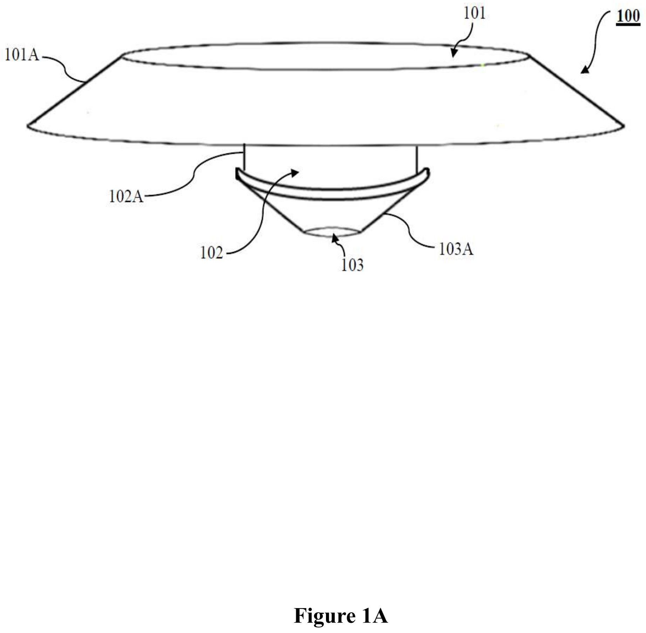

To overcome the aforementioned drawbacks, the present disclosure envisages a scratch protection guard which will be described with reference to Figures 1A to 2C.

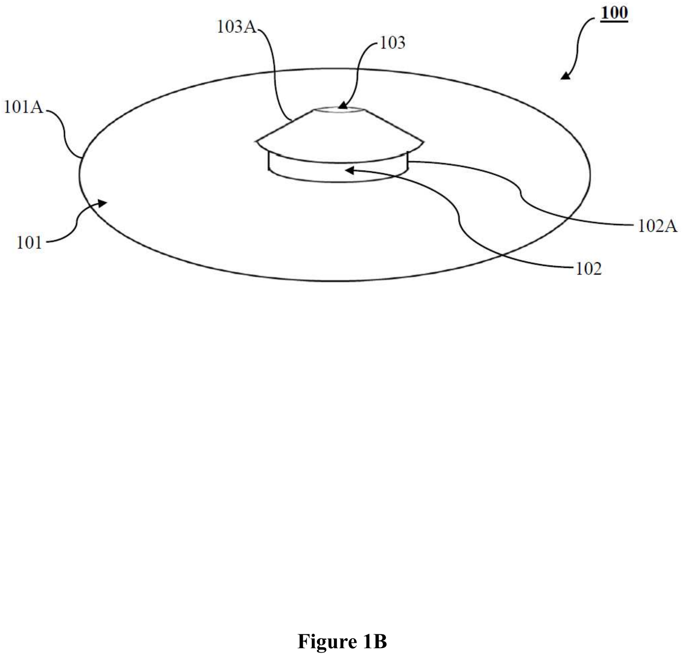

**Figure 1A** illustrates a top-perspective view of a scratch protection guard, and **Figure 1B** illustrates a bottom-perspective view of the scratch protection guard, in accordance with an embodiment of the present disclosure.

As illustrated in **Figures 1A** and **1B**, the scratch protection guard **100** is designed as a button-like structure so that it can provide both scratch prevention and thermal dissipation. In an embodiment, the scratch protection guard **100** includes a top section **101**, a middle section **102**, and a bottom section **103.** The top section **101** has a pre-formed portion **101a** that remain visible on a top surface of a shelf **200** after installation. The Shelf **200** generally refers to a flat horizontal surface used for holding or storing objects. It may be a standalone unit or part of a larger structure like a cabinet, rack, or wall. In an embodiment, the pre-formed portion **101a** is shaped as a frustum to provide a sliding surface to a sliding component **300.** When the sliding component 300 is slid over the shelf surface, the frustum shape of the pre-formed portion **101a** provides a smooth lift to the sliding surface of the sliding component **300** over the shelf surface thereby providing an air gap between the sliding component **300** and the shelf **200** which is based on thickness of the pre-formed portion **101a**. The pre-formed portion **101a** of the top section **101** is shaped and sized to provide a physical barrier between the sliding component and the shelf, thereby preventing mechanical damage during relative motion. In an embodiment, structural strength of the guard may be predesigned or configured to provide resistance against the impact forces from the sliding component **300** when slid over the pre-formed portion **101a**.

In a further embodiments, the material selection for the top section **101** may be selected based on specific application. In one embodiment, the top section **101** may be provided with a textured surface to increase friction and prevent unwanted movement of the sliding component **300** when it is in contact with the guard **100**. In another embodiment, in order to observe the heat generated by electronic components placed on the shelf **200**, the top section **101** may be coated with a thermally conductive material to improve heat dissipation from electronic components mounted on the shelf. In yet another embodiment, the top section **101** may be provided with integrated cooling fins to increase surface area for heat dissipation. In yet another embodiment, material of the top section **101** may include anti-static properties to prevent electrostatic discharge in sensitive electronic environments. The top section **101** may be designed with a low-profile configuration to minimize obstruction while providing adequate protection and thermal dissipation.

In an implementation, one or more customized modifications may be provided for the top section **101** for easy identification, mounting of shelfs and guard replacement. In an example, the pre-formed portion **101a** may be embossed with identification markings for quick visual inspection and inventory management. Further, the pre-formed portion **101a** may have a modular design that allows for customization based on specific requirements of different shelving systems. In another embodiment, the top section **101** may be provided with a detachable cover (*now shown*) that provides additional protection to the pre-formed portion **101a** and can be replaced independently if worn out.

The scratch protection guard **100** further includes a middle section **102** which includes a cylindrical portion **102a** that passes through a slot **204** of the shelf. In one embodiment, one or more slots **204** are formed on the shelf of predetermined size and shape to accommodate the guard **100**. When the guard **100** is fixed on the shelf surface, the cylindrical portion **102a** of the middle section **102** passes through the slot. In an embodiment, the height of the cylindrical portion **102a** is equal to the thickness of the shelf. In an embodiment, the cylindrical portion **102a** has a cross-sectional shape selected from the group consisting of circular, rectangular, square, or any other regular shape. Further, in yet another embodiment, the cylindrical portion **102a** of the middle section **102** may include a taper or threading to facilitate a secure fit within the slot **204** of the shelf.

The scratch protection guard **100** further includes a bottom section **103** having a deformable portion **103a**. In an embodiment, the deformable portion **103a** has an inverted frustum shape that deforms during passes through the slot of the shelf **200** and regains its original shape after passing through the slot of the shelf to secure the scratch protection guard **100** on the shelf. The frustum shape of deformable portion **103a** is designed to act as a locking mechanism that automatically engages upon full insertion through the slot **204** of the shelf. In an embodiment, the deformable portion **103a** of the bottom section **103** is configured to automatically return to its original shape after deformation due to its memory-like material properties. In an embodiment, the deformable portion **103a** of the bottom section **103** may be made from a thermoplastic elastomer material to provide enhanced flexibility and wear resistance.

The design of the deformable portion **103a** may be provided for its flexible insertion into the slot **204**. In one embodiment, the deformable portion **103a** of the bottom section **103** is configured with radial slots or grooves to enhance its flexibility during insertion into the slot **204** of the shelf. In yet another embodiment, the bottom section **103** includes a retention flange that prevents over-insertion through the slot of the shelf, ensuring precise alignment. In a further embodiment, the deformable portion **103a** may include a reinforcing rib structure to improve its strength and durability under repeated loading cycles.

In an embodiment, the scratch protection guard **100** is made of Polyether ether ketone (PEEK) plastic, chosen for its high durability, ability to withstand operating temperatures up to 260°C, and a melting point of 343°C. This makes the scratch protection guard **100** suitable for use in environments where temperature regulation is critical, such as data centers and telecom equipment assemblies. Thus, the body material properties of the scratch protection guard **100** ensure long-term resistance to wear and tear.

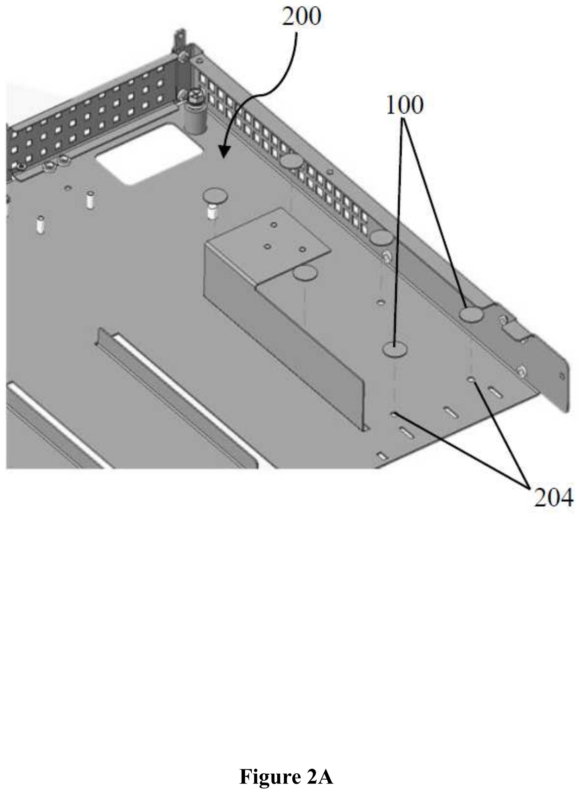

**Figure 2A** illustrates a perspective view of an exemplary configurations and placements of multiple scratch protection guards on a shelf, according to an embodiment of the present disclosure. As illustrated, the shelf **200** includes a number of slots **204**. In these slots **204**, the scratch protection guards **100** are snap-fitted by pushing the bottom section **103** of each scratch protection guard **100** against the slots **204**. As mentioned above, the bottom section **103** includes the deformable portion **103a,** which deforms slightly during insertion into corresponding slot **104** on the shelf **200**. Once inserted, the deformable portion **103a** returns to its original shape, securing the scratch protection guard **100** firmly in place on the shelf **200**. The deformable portion **103a** of each scratch protection guard **100** ensures snap-fit installation into the slots of the shelf, allowing for easy installation and removal without the need for additional hardware or tools.

Further, as can be seen from **Figure 2A**, the scratch protection guards **100** are mounted at strategic points on the shelf **200** where the contact with a sliding component, say, an expansion box, is most likely to occur. The expansion box in the context of a shelf typically refers to enclosures or units that can be slidably added to an existing shelf to increase its capacity, functionality, or storage space. These expansion boxes are often modular components that are integrated or slided into the shelves of rack-mounted systems, storage units, or other setups to provide scalability. The scratch protection guards **100** can be mounted or arranged on the surface of the shelf **200** depending on the size and configuration of the shelf **200** and the sliding component **300**. In a further embodiment, plurality of the scratch protection guard **100** is distributed in a predefined pattern that corresponds to expected motion path of the sliding component **300** to maximize protection coverage. In a further embodiment, the plurality of scratch protection guards **100** are spaced apart at a distance calculated to distribute the load evenly when the sliding component is in motion.

In a further embodiment, an adhesive layer or bonding agent may be provided between the scratch protection guard and the shelf to enhance stability and prevent accidental dislodgment.

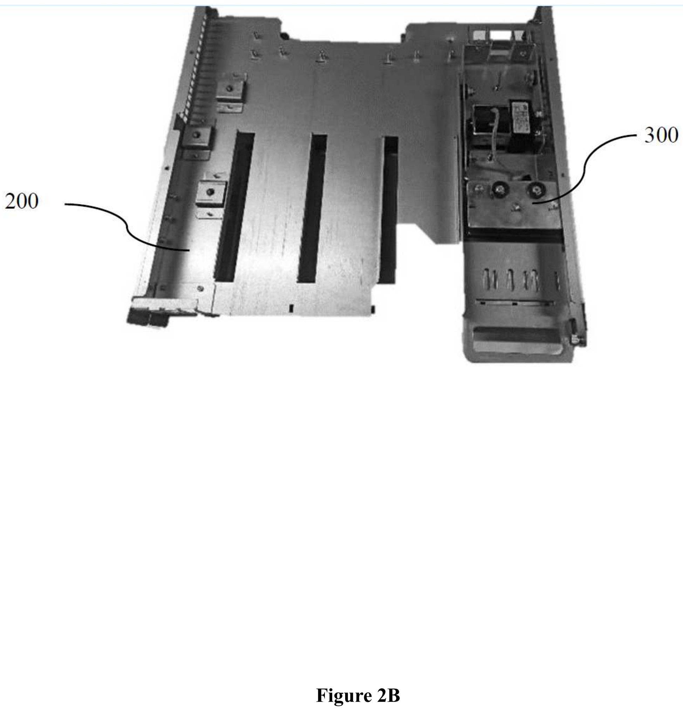

**Figure 2B** illustrates a perspective view of a sliding component **300** mounted on the shelf **200**, according to an embodiment of the present disclosure. As can be seen, the sliding component **300** covers one longitudinal side of the shelf **200**. Accordingly, the area beneath the sliding component **300** is required to be protected from the scratches due to the sliding movement of the sliding component. For this, the scratch protection guards **100** are evenly mounted on the surface of the shelf **200** beneath the sliding component **300.**

In an embodiment, the plurality of scratch protection guards **100** are evenly distributed along the shelf **200** in areas beneath the sliding component **300** to protect the shelf surface from scratches caused by the movement of the sliding component **300**.

In a further embodiment, the sliding component **300** is equipped with complementary alignment features that interface with the pre-formed portion **101a** of the scratch protection guard **100** to ensure a smooth and guided sliding motion.

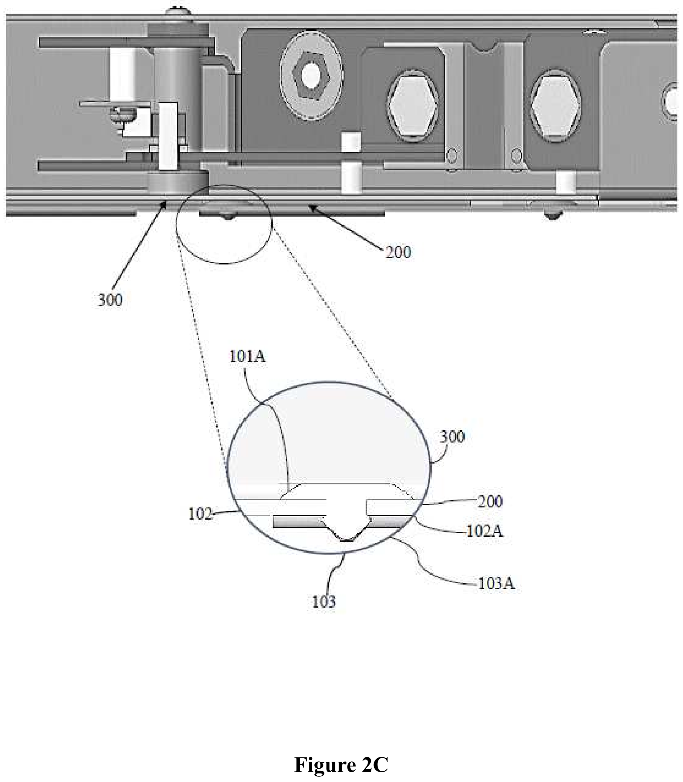

**Figure 2C** illustrates a cross-sectional view of the sliding component mounted on the shelf. The sliding component **300** slides along the shelf **200**, and the sliding component **300** make contacts with the pre-formed portion **101a** of the scratches protection guard **100**. The pre-formed portion **101a** of the top section **101** prevents direct contact between the shelf **200** and the sliding component **300**, thereby eliminating the risk of scratches. Further, the scratch protection guard's **100** pre-formed portion **101a** in the top section **101** prevents direct contact between the shelf and the sliding component, thereby providing a protective barrier against wear and tear.

Also, by having the pre-formed portion **101a** of the top section **101**, an air gap is maintained between the shelf **200** and the sliding component **300**, thereby ensuring the dissipation of heat from the electronic components mounted on the sliding component **300**. The air gap created by the pre-formed portion **101a** of the scratch protection guard reduces heat transfer between the shelf **200** and the sliding component **300**, thereby enhancing cooling efficiency. In an embodiment, the scratch protection guard **100** material is capable of withstanding operating temperatures up to 260°C and has a melting point of approximately 343°C, providing long-term resistance to thermal stress in environments like data centers and telecom equipment assemblies. Further, the scratch protection guard **100** is designed to withstand mechanical vibrations and shocks, maintaining its position and effectiveness even under dynamic loading conditions.

In an embodiment, the scratches protection guard **100** allows for easy installation and removal, ensuring that the sliding component **300** can be securely anchored or supported on the shelf **200** without additional hardware or tools. A mechanism may be provided for easy replacement of the scratch protection guard **100** without the need to disassemble the entire shelf **200** or sliding component assembly.

Also disclosed are the following numbered items:
1. A shelf assembly, comprising:
   a shelf **200** having a plurality of slots **204** strategically positioned to receive scratch protection guards;
   a plurality of scratch protection guards **100** mounted in the slots **204** of the shelf **200**, each scratch protection guard comprising:
      a top section **101** with a pre-formed frustum-shaped portion **101a** visible on a surface of the shelf, wherein the pre-formed portion **101a** is shaped as a frustum to provide a sliding surface to a sliding component **300**;
      a middle section **102** with a cylindrical portion that fits through the slot of the shelf;
      a bottom section **103** with a deformable inverted frustum-shaped portion **103a** that deforms during insertion and regains its original shape to secure the scratch protection guard within the slot 204.
2. The shelf assembly as in item 1, wherein the scratch protection guard **100** is positioned at contact points where the sliding component **300** is most likely to come into contact with the shelf to prevent scratching and facilitate thermal dissipation.
3. The shelf assembly as in claim 1 or 2, wherein the deformable portion **103a** of each scratch protection guard **100** ensures snap-fit installation into the slots of the shelf, allowing for easy installation and removal without the need for additional hardware or tools.
4. The shelf assembly as in any of items 1 to 3, further comprises an adhesive layer or bonding agent between the scratch protection guard and the shelf to enhance stability and prevent accidental dislodgment.
5. The shelf assembly as in any of items 1 to 4, wherein the scratch protection guard **100** is distributed in a predefined pattern that corresponds to expected motion path of the sliding component **300** to maximize protection coverage.
6. The shelf assembly as in any of items 1 to 5, wherein the scratch protection guards **100** are spaced apart at a distance calculated to distribute load evenly when the sliding component is in motion.
7. A system for protecting and enhancing longevity of a shelf during operation of a sliding component, the system comprises:
   a shelf **200** having a surface with a plurality of slots **204**;
   a sliding component **300** mounted on the shelf **200**;
   a plurality of scratch protection guards **100** installed in the slots **204** of the shelf, each scratch protection guard **100** comprising:
      a top section **101** with a pre-formed frustum-shaped portion **101a** that maintains an air gap between the shelf **200** and the sliding component **300** to facilitate thermal dissipation;
      a middle section **102** with a cylindrical portion **102a** passing through the slots in the shelf **200**;
      a bottom section **103** with a deformable portion **103a** configured to secure the scratch protection guard within the slot **204** upon insertion.
8. The system as in item 7, wherein the scratch protection guards **100** are evenly distributed along the shelf **200** in areas beneath the sliding component **300** to protect the shelf surface from scratches caused by movement of the sliding component **300**.
9. The system as in item 7 or 8, wherein the scratch protection guard's **100** pre-formed portion **101a** in the top section **101** prevents direct contact between the shelf and the sliding component, thereby providing a protective barrier against wear and tear.

The present disclosure described herein above has several technical advantages including, but not limited to, a scratch protection guard that: prevents surface damage and enhances heat dissipation, provides a secure and durable attachment, allows for easy installation and maintenance, easily replaceable, is user-friendly for industrial operators, and ensures uniform protection across the shelf and is also adaptable to various designs.

The embodiments herein and the various features and advantageous details thereof are explained with reference to the non-limiting embodiments in the following description. Descriptions of well-known components and processing techniques are omitted so as to not unnecessarily obscure the embodiments herein. The examples used herein are intended merely to facilitate an understanding of ways in which the embodiments herein may be practiced and to further enable those of skill in the art to practice the embodiments herein. Accordingly, the examples should not be construed as limiting the scope of the embodiments herein.

The foregoing description of the specific embodiments so fully reveals the general nature of the embodiments herein that others can, by applying current knowledge, readily modify and/or adapt for various applications such specific embodiments without departing from the generic concept, and, therefore, such adaptations and modifications should and are intended to be comprehended within the meaning and range of the disclosed embodiments. It is to be understood that the phraseology or terminology employed herein is for the purpose of description and not of limitation. Therefore, while the embodiments herein have been described in terms of preferred embodiments, those skilled in the art will recognize that the embodiments herein can be practiced with modification within the scope of the embodiments as described herein.

The use of the expression "at least" or "at least one" suggests the use of one or more elements or ingredients or quantities, as the use may be in the embodiment of the disclosure to achieve one or more of the desired objects or results.

As used herein, the terms "include", "comprises", "including" and/or "comprising" when used in this specification, specify the presence of stated features, operations, elements, and/or components, but do not preclude the presence or addition of one or more other features, steps, operations, elements, components, and/or groups thereof. It will be understood that when an element is referred to as being "connected" or "coupled" to another element, it can be directly connected or coupled to the other element or intervening elements may be present. Furthermore, "connected" or "coupled" as used herein may include operatively connected or coupled. As used herein, the term "and/or" includes any and all combinations and arrangements of one or more of the associated listed items.

Unless otherwise defined, all terms (including technical and scientific terms) used herein have the same meaning as commonly understood by one of ordinary skills in the art to which this disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

## Claims

1. A scratch protection guard **(100),** comprising:
a top section **(101)** having a pre-formed portion **(101a)** configured to remain visible on a top surface of a shelf **(200)** after installation, wherein the pre-formed portion **(101a)** is shaped as a frustum to provide a sliding surface to a sliding component **(300)**;
a middle section **(102)** including a cylindrical portion **(102a)** configured to pass through a slot **(204)** of the shelf **(200)**, wherein the cylindrical portion **(102a)** has a height substantially equal to a thickness of the shelf **(200)**; and
a bottom section **(103)** having a deformable portion **(103a)** shaped as an inverted frustum, wherein the deformable portion **(103a)** is configured to deform during insertion into the slot **(204)** of the shelf **(200)** and return to its original shape after insertion to secure the scratch protection guard on the shelf **(200)**.

2. The scratch protection guard as claimed in claim 1, wherein the cylindrical portion has a cross-sectional shape selected from the group consisting of circular, rectangular, square, or any other regular shape.

3. The scratch protection guard as claimed in claim 1 or 2, wherein said scratch protection guard is made of polyether ether ketone "PEEK" plastic, enabling durability and heat resistance suitable for use in environments where temperature regulation is critical.

4. The scratch protection guard as claimed in any preceding claim, wherein the pre-formed portion of the top section is configured to provide a physical barrier between the sliding component and the shelf, thereby preventing mechanical damage during relative motion.

5. The scratch protection guard as claimed in any preceding claim, wherein the frustum shape of the pre-formed portion is designed to enhance structural strength of the guard, providing resistance against impact forces from the sliding component.

6. The scratch protection guard as claimed in any preceding claim, wherein the top section comprises a textured surface to increase friction and prevent unwanted movement of the sliding component when it is in contact with the guard.

7. The scratch protection guard as claimed in any preceding claim, wherein the cylindrical portion of the middle section includes a taper or threading to facilitate a secure fit within the slot of the shelf.

8. The scratch protection guard as claimed in any preceding claim, wherein the deformable portion of the bottom section is configured with radial slots or grooves to enhance its flexibility during insertion into the slot of the shelf and/or wherein the deformable portion's inverted frustum shape is designed to act as a locking mechanism that automatically engages upon full insertion through the slot of the shelf.

9. The scratch protection guard as claimed in any preceding claim, wherein the top section is coated with a thermally conductive material to improve heat dissipation from electronic components mounted on the shelf and/or wherein the bottom section includes a retention flange that prevents over-insertion through the slot of the shelf, ensuring precise alignment.

10. The scratch protection guard as claimed in any preceding claim, further comprising integrated cooling fins on the top section to increase surface area for heat dissipation.

11. The scratch protection guard as claimed in any preceding claim, wherein the pre-formed portion is embossed with identification markings for quick visual inspection and inventory management and/or wherein the pre-formed portion has a modular design that allows for customization based on specific requirements of different shelving systems and/or wherein material of the top section includes anti-static properties to prevent electrostatic discharge in sensitive electronic environments.

12. The scratch protection guard as claimed in any preceding claim, wherein the deformable portion of the bottom section is configured to automatically return to its original shape after deformation due to its memory-like material properties and/or wherein the deformable portion of the bottom section is made from a thermoplastic elastomer material to provide enhanced flexibility and wear resistance and/or wherein the deformable portion includes a reinforcing rib structure to improve its strength and durability under repeated loading cycles.

13. The scratch protection guard as claimed in any preceding claim, wherein the top section is designed with a low-profile configuration to minimize obstruction while providing adequate protection and thermal dissipation and/or wherein the top section includes a detachable cover that provides additional protection to the pre-formed portion and can be replaced independently if worn out.

14. A shelf assembly, comprising:
a shelf **200** having a plurality of slots **204** strategically positioned to receive scratch protection guards;
a plurality of scratch protection guards **100** according to any preceding claim.

15. A system for protecting and enhancing longevity of a shelf during operation of a sliding component, the system comprises:
a shelf **200** assembly according to claim 14;
a sliding component **300** mounted on the shelf **200**;
a plurality of scratch protection guards **100** installed in the slots **204** of the shelf, each scratch protection guard **100** comprising:
a top section **101** with a pre-formed frustum-shaped portion **101a** that maintains an air gap between the shelf **200** and the sliding component **300** to facilitate thermal dissipation;
a middle section **102** with a cylindrical portion **102a** passing through the slots in the shelf **200**;
a bottom section **103** with a deformable portion **103a** configured to secure the scratch protection guard within the slot **204** upon insertion.
